# EUROPÄISCHE PATENTANMELDUNG

(11) **EP 3 417 982 A1**
(43) Veröffentlichungstag der Anmeldung: **26.12.2018**
(21) Anmeldenummer: 17177113.2
(22) Anmeldetag: 21.06.2017
(51) Int. Cl.: B23K 26/00, B23K 26/402, C04B 37/02, B23K 26/359, B23K 26/364, B23K 26/0622, B23K 103/12, B23K 103/18, B23K 103/00

(54) **LASERSCHNEIDEN VON METALL-KERAMIK-SUBSTRATEN**

(71) Anmelder: Heraeus Deutschland GmbH & Co. KG, 63450 Hanau (DE)
(72) Erfinder: ROGG, Alexander, 92724 Trabitz (DE); LISCA, Bogdan, 30781 Samnihaiu Roman (RO)
(74) Vertreter: Gille Hrabal

(57) **Zusammenfassung**

Beschrieben wird zur Ablation von einem Metall-Keramik-Substrat, wobei das Verfahren mit einem Laser durchgeführt wird, der unter Verfahrensbedingungen angewendet wird, welche die Bildung von festen Metallpartikeln auf dem Metall-Keramik-Substrat, die sich in der Umgebung der Ablationskante aus durch die Laserablation freigesetzten Metallpartikeln abscheiden können, im Wesentlichen vermeiden. Weiterer Gegenstand ist Keramik-Metall-Substrat, umfassend ein Keramik-Substrat und auf mindestens einer Seite des Keramiks-Substrats eine Metallisierung, wobei das Keramik-Substrat und die Metallisierung bündige Schneidkante aufweisen.

## Beschreibung

Die vorliegende Erfindung betrifft ein Verfahren zum Laserschneiden von Metall-Keramik-Substraten. Weiterer Gegenstand der vorliegenden Erfindung ist ein mit dem erfindungsgemäßen Verfahren erhaltenes Metall-Keramik-Substrat sowie die Verwendung von einem Laser zum Schneiden von Metall-Keramik-Substraten.

Laserschneiden, auch Laserstrahlschneiden, bezeichnet das Durchtrennen von Festkörpern mittels kontinuierlicher oder gepulster Laserstrahlung durch Materialablation. Nahezu jede Art von Werkstoff, beispielsweise Metalle, Dielektrika und organische Materialien, können nach dem Stand der Technik mit Laserstrahlung geschnitten werden. Ein Problem, das sich insbesondere bei dem Schneiden von Metallmaterialien mit Laserstrahlen ergibt, sind Partikelemissionen, die zu unerwünschten Metallabscheidungen in der Nähe der Laserschneidlinie führen können. Entsprechende Abscheidungen sind insbesondere bei der Bearbeitung von Kupferschichten in elektronischen Bauteilen, beispielsweise in DCB-Substraten, störend. Diese Abscheidungen können eine Reduzierung der elektrischen Isolation und eine Reduzierung der Isolationsstrecke bewirken, was schlussendlich zu einer Zerstörung der auf dem DCB-Substrat basierenden Schaltung führen kann.

Direct Copper Bonding Substrate (DCB, auch DBC genannt) sind die am häufigsten verwendeten Schaltungsträger für Leistungselektronik-Anwendungen. Die DCB-Technologie ist eine Fügetechnologie, durch welche bei hohen Temperaturen eine eutektische Verbindung zwischen Kupfer (in der Regel als Kupferfolie) und einer Keramik erzeugt wird. Die DCB-Substrate eignen sich für Anwendungen mit hohen Leistungen, die eine gute Wärmeentkoppelung erfordern.

DCBs bestehen aus einem Keramik-Substrat wie Al₂O₃ (oder anderen Keramikmaterialien wie z. B. ZTA, AIN, Siliziumnitrid (Si₃N₄)), das als Isolierungsschicht dient, und Kupferverbindungen, um die elektrische Leitfähigkeit zu gewährleisten. Das DCB-Substrat stellt das Rückgrat der Leistungselektronik-Module dar und ist - beispielsweise im Vergleich zu einer gedruckten Leiterplatte (PCB = Printed Circuit Board) - außerordentlich leistungsfähig. Zum einen trägt es die Halbleiterchips und dient zur Wärmeableitung. Zum anderen gewährleistet es die Isolierung hin zum Kühlkörper und zum Umrichtergehäuse.

Für eine optimale Zuverlässigkeit und Performance muss das Modul gute Eigenschaften in Bezug auf Wärmeverteilung und Temperatur- sowie Lastwechselbeständigkeit aufweisen.

Hierbei stellen insbesondere Delaminierungserscheinungen der einzelnen Schichten eine Herausforderung dar.

Metall-Keramik-Substrate, welche beispielsweise nach dem DCB-Verfahren erhalten werden, weisen üblicherweise funktionale Ausnehmungen auf. Hierbei handelt es sich zum Beispiel um Löcher, über welche die Metall-Keramik-Substrate durch Verschraubungen befestigt werden, oder Durchkontaktierungen (Vias).

Das Einbringen derartiger Ausnehmungen erfolgt üblicherweise durch Wegätzen der Metallbeschichtung und einem anschließenden Durchtrennen des Keramik-Substrats, beispielsweise durch Laserablation. Hierdurch resultieren Kantenstrukturen der Metall-Keramik-Substrate, bei denen die Metallkante gegenüber der Keramikkante zurückversetzt ist.

Eine gegenüber der Keramikkante zurückversetzte Metallkante weist den Nachteil auf, dass die resultierenden Metall-Keramik-Substrate weniger stabil sind und es bei Temperatur- sowie Lastwechseln zu einer Delamination der Metallschicht von dem Substrat kommen kann. Ein weiterer Nachteil einer zurückversetzten Metallkante ist die reduzierte mechanische Stabilität des Keramik-Substrats, die sich beispielsweise durch die Ausbildung von Rissen manifestieren kann.

Darüber hinaus erfordert das konventionelle Einbringen von Ausnehmungen in das Metall-Keramik-Substrat einen wie oben schon beschriebenen zweistufigen Prozess des Wegätzens der Metallbeschichtung und der Laserablation des Keramik-Substrats, was unter wirtschaftlichen Gesichtspunkten nachteilig ist.

Ausgehend von diesem Stand der Technik stellt sich die vorliegende Erfindung zunächst die Aufgabe, ein Verfahren zur Laserablation von Metall-Keramik-Substraten bereitzustellen, mit welchem Metall-Keramik-Substrate mit Ausnehmungen in der Metallschicht und/oder dem Keramik-Substrat bereitgestellt werden können, die eine stabile elektrische Isolation aufweisen.

Eine weitere Aufgabe der vorliegenden Erfindung ist die Bereitstellung von einem mit Ausnehmungen in der Metallschicht und/oder dem Keramik-Substrat versehenem Metall-Keramik-Substrat, das vorzugsweise mechanisch stabil ist und vorzugsweise keine Risse aufweist.

Das Verfahren der Laserablation von Metall-Keramik-Substraten, umfassend ein Keramik-Substrat und mindestens eine darauf vorgesehene Metallschicht, soll vorzugsweise eine wirtschaftliche Fertigung der Metall-Keramik-Substrate ermöglichen.

Gelöst werden diese Aufgaben durch ein Verfahren zur Ablation von einem Metall-Keramik-Substrat. Das erfindungsgemäße Verfahren ist dadurch gekennzeichnet, dass das Verfahren mit einem Laser durchgeführt wird, der unter Verfahrensbedingungen angewendet wird, welche die Bildung von festen Metallpartikeln auf dem Metall-Keramik-Substrat, die sich in der Umgebung der Ablationskante aus durch die Laserablation freigesetzten Metallpartikeln abscheiden können, im Wesentlichen vermeiden.

Des Weiteren werden die Aufgaben vorzugsweise durch ein Verfahren zur Ablation von einem Metall-Keramik-Substrat gelöst, bei welchem ein Laser verwendet wird, der unter Verfahrensbedingungen angewendet wird, welche die gleichzeitige Laserablation von einer Metallschicht und einem Keramik-Substrat ermöglichen.

Wenn das erfindungsgemäße Verfahren unter Verfahrensbedingungen durchgeführt wird, bei welchen die Bildung von Metallpartikeln auf dem Metall-Keramik-Substrat, die sich in der Umgebung der Ablationskante aus durch die Laserablation freigesetzten Metallpartikeln abscheiden können, im Wesentlichen vermieden wird, wird ein Metall-Keramik-Substrat mit stabilen Isolationseigenschaften erhalten, da die Isolationseigenschaften durch die Abscheidung von Metallpartikeln auf dem Metall-Keramik-Substrat nicht gestört werden.

Wenn das erfindungsgemäße Verfahren unter Verfahrensbedingungen durchgeführt wird, bei welchen die gleichzeitige Laserablation von einer Metallschicht und einem Keramik-Substrat möglich ist, wird einerseits ein wirtschaftliches Verfahren, das weitere Verfahrensschritte erfordert, vermieden und gleichzeitig wird ein Metall-Keramik-Substrat erhalten, dass eine bündige Kante der Metallisierung und des Keramik-Substrats aufweist. Hierdurch wird ein Metall-Keramik-Substrat bereitgestellt, das mechanisch stabil ist und bei Temperatur- sowie Lastwechseln eine Delamination der Metallschicht von dem Substrat vermeidet.

Das mit dem erfindungsgemäßen Verfahren bearbeitete Metall-Keramik-Substrat ist im Wesentlichen frei von Metallpartikeln an den Seiten der durch Laserablation gebildeten Kante. Der Begriff "im Wesentlichen frei von Metallpartikeln" ist im Rahmen der vorliegenden Erfindung so zu verstehen, dass die durch die Laserablation gebildeten Rückstände der Metallpartikel so gering sind, dass hierdurch die Isolationseigenschaften des Metall-Keramik-Substrats nicht in einem Umfang verschlechtert werden, die eine Anwendung des Metall-Keramik-Substrats als Schaltungsträger für Leistungselektronik-Anwendungen beeinträchtigt.

Das erfindungsgemäße Verfahren stellt insbesondere darauf ab, dass Metallpartikel durch die Laserablation an den Seiten der durch Laserablation gebildeten Kante im Wesentlichen vermieden werden. Der Bereich "an den Seiten der durch Laserablation gebildeten Kante" ist im Rahmen der vorliegenden Erfindung insbesondere als der Bereich des Metall-Keramik-Substrats zu verstehen, auf welchem bei Anwendung von anderen als den erfindungsgemäßen Verfahrensbedingungen die Abscheidung von Metallpartikeln auftritt.

Die Abscheidungen erstrecken sich in der Ausnehmung und/oder in einem Bereich im Wesentlichen parallel zu den jeweils durch Laserablation erzeugten Kanten der Ausnehmungen in einer Breite, berechnet von der Kante der Ausnehmung, von im Allgemeinen höchstens 200 µm, vorzugswiese höchstens 100 µm, vorzugswiese höchstens 50 µm, vorzugweise höchstens 45 µm, weiter bevorzugt höchstens 40 µm, weiter bevorzugt höchstens 35 µm, noch weiter bevorzugt höchstens 30 µm.

Dieser Bereich betrifft die durch die Laserablation erzeugte Ausnehmung in dem Metall-Keramik-Substrat. Daher wird insbesondere unter dem Begriff "im Wesentlichen frei von Metallpartikeln an den Seiten der durch Laserablation gebildeten Kante" ("Umgebung der Ablationskante") im Rahmen der vorliegenden Erfindung verstanden, dass durch die Laserablation weniger als 50 Flächen.-%, bevorzugt weniger als 40 Flächen.-%, weiter bevorzugt weniger als 20 Flächen.-%, weiter bevorzugt weniger als 10 Flächen.-%, weiter bevorzugt weniger als 5 Flächen.-%, in dem vorgenannten Breitenbereich mit durch Laserablation erzeugte Metallpartikeln belegt sind.

Im Folgenden werden bevorzugte Ausführungsformen des Lasers beschrieben, mit welchen die Bildung von Metallpartikeln bei der Laserablation von Metall-Keramik-Substraten im Wesentlichen verhindert werden kann und mit welchen eine gleichzeitige Laserablation einer Metallschicht und eines Keramik-Substrats möglich ist.

Im Rahmen der vorliegenden Erfindung kann der Laser ausgewählt sein aus einem n-sec-Laser, p-sec-Laser oder f-sec-Laser, wobei allerdings erfindungsgemäß die Verwendung eines p-sec-Laser bevorzugt ist.

Ferner ist weiter bevorzugt, wenn der p-sec-Laser eine Pulsdauer, d.h. eine Dauer des Laserpulses, von vorzugsweise 0,10 bis 100,00 ps, weiter bevorzugt 0,50 bis 50,00 ps, noch weiter bevorzugt 1,00 bis 30,00 ps, aufweist. Mit der gewählten Pulsdauer ist es möglich, den Laserprozess so zu führen, dass im Wesentlichen keine Rückstände des Metalls entstehen und somit im Wesentlichen keine Metallpartikel, die sich auf der Oberfläche des Metall-Keramik-Substrats niederschlagen, gebildet werden. Da im Rahmen der vorliegenden Erfindung im Wesentlichen nur kalte Stäube und keine Schmelzphasen entstehen und aufgrund eines ausreichend groß gewählten Abstandes von Strahlquelle zu Substratoberfläche ist die Verwendung eines Prozessgases zwar möglich, nicht jedoch zwingend erforderlich.

Die Bearbeitungsgeschwindigkeit des Lasers beträgt vorzugsweise mindestens 0,50 m/sec, weiter bevorzugt mindestens 0,60 m/sec, weiter bevorzugt mindestens 0,70 m/sec, weiter bevorzugt mindestens 0,80 m/sec, weiter bevorzugt mindestens 1,00 m/sec.

Die Bearbeitungsgeschwindigkeit des Lasers beträgt vorzugsweise höchstens 10,00 m/sec, weiter bevorzugt höchstens 8,00 m/sec, weiter bevorzugt höchstens 6,00 m/sec, weiter bevorzugt höchstens 5,00 m/sec, weiter bevorzugt höchstens 4,00 m/sec.

Die Bearbeitungsgeschwindigkeit des Lasers beträgt vorzugsweise 0,50 bis 10,00 m/sec, weiter bevorzugt 0,60 bis 8,00 m/sec, weiter bevorzugt 0,70 bis 6,00 m/sec, weiter bevorzugt 0,80 bis 5,00 m/sec, weiter bevorzugt 1,00 bis 4,00 m/sec.

Es hat sich erfindungsgemäß herausgestellt, dass bei zu niedrigen Bearbeitungsgeschwindigkeiten, insbesondere bei Bearbeitungsgeschwindigkeiten des Lasers unterhalb von 0,5 m/s, die Bildung von Metallpartikeln, die sich auf der Oberfläche des Metall-Keramik-Substrats niederschlagen, im Allgemeinen nicht vermieden lässt. Daher sind erfindungsgemäß Bearbeitungsgeschwindigkeiten des Lasers von mehr als 0,5 m/s bevorzugt.

Die durch die Laserablation erzeugten Metallpartikel können sich im Rahmen der vorliegenden Erfindung sowohl auf der Metallisierung als auch auf dem Keramik-Substrat abscheiden.

In dem erfindungsgemäßen Verfahren ist es möglich, dass das Durchschneiden des Metall-Keramik-Substrats in einer Überfahrt oder in mehreren Überfahrten des Lasers erzeugt wird.

Dabei ist ein Durchschneiden nur von der Metallisierung als auch von der Metallisierung und des Metall-Keramik-Substrats möglich.

Die Pulsenergie, d.h. der Energiegehalt eines einzelnen Laserpulses, beträgt vorzugsweise 10,00 bis 500,00 µJ, weiter bevorzugt 50,00 bis 400,00 µJ, noch weiter bevorzugt 100,00 bis 350,00 µJ.

Der p-sec-Laser weist vorzugsweise eine Leistung von 20,00 bis 400,00 W, weiter bevorzugt 40,00 bis 200,00 W, noch weiter bevorzugt 50,00 bis 180,00 W, noch weiter bevorzugt 60,00 bis 160,00 Watt, noch weiter bevorzugt 80 bis 130,00 Watt, noch weiter bevorzugt 90,00 bis 120,00 Watt, auf.

In einer bevorzugten Ausführungsform der vorliegenden Erfindung handelt es sich bei dem verwendeten Laser um einen IR-Laser.

Die zugrundeliegenden Aufgaben der vorliegenden Erfindungen werden insbesondere durch die Verwendung eines IR-Lasers, weiter bevorzugt eines p-sec-IR-Lasers, gelöst, wobei, ohne an eine Theorie gebunden zu sein, davon ausgegangen wird, dass das Licht des p-sec- IR-Strahls in die Oberfläche des Metallmaterials besonders wirkungsvoll einkoppelt, d.h. von dem Metallmaterial besonders wirkungsvoll absorbiert wird. Darüber hinaus weist ein IR-Laser eine hohe Energieeffizienz auf, was zur Lösung der obenstehenden Aufgaben ebenfalls von Vorteil ist.

Ein weiterer Vorteil der Verwendung von einem IR-Laser zur Bearbeitung von Metallmaterialien des Metall-Keramik-Substrats ist, dass das IR-Laserlicht direkt aus Diodenlicht erzeugt werden kann, wohingegen grünes Laserlicht erst aus IR-Laserlicht mit einem Wirkungsgrad von 60 % hergestellt werden muss und UV-Laserlicht wiederum aus grünem Laserlicht mit einem weiteren Wirkungsgrad von ebenfalls 60 % hergestellt werden muss.

Im Gegensetz zu beispielsweise einem CO₂-Laser kann der p-sec-IR-Laser deutlich weiter von dem zu bearbeitendem Metallmaterial entfernt angeordnet werden, wodurch sich eine höhere Tiefenschärfe realisieren lässt.

Mithilfe eines IR-Lasers kann darüber hinaus gegenüber einem CO₂-Laser eine ausreichend hohe Tiefenschärfe realisiert werden.

Wenn im Rahmen der vorliegenden Erfindung ein IR-Laser verwendet wird, so beträgt die Frequenz des IR-Lasers vorzugsweise 350 bis 650 kHz, weiter bevorzugt 375 bis 625 kHz, noch weiter bevorzugt 400 bis 600 kHz.

Wenn im Rahmen der vorliegenden Erfindung ein IR-Laser verwendet wird, so beträgt die Pulsenergie des IR-Lasers vorzugsweise 100 bis 300 µJ, weiter bevorzugt 125 bis 275 µJ, noch weiter bevorzugt 150 bis 250 µJ.

Das erfindungsgemäße Verfahren kann in Gegenwart eines Prozessgases durchgeführt werden. Bei dem Prozessgas handelt es sich beispielsweise um Sauerstoff.

Das erfindungsgemäße Verfahren wird vorzugsweise in einer Vorrichtung durchgeführt, die eine Absaugvorrichtung aufweist, die Stäube absorbiert, welche durch die Laserbearbeitungen entstehen.

Teilweise besteht Bedarf, Konturen in Metallmaterial eines Metall-Keramik-Substrats einzubringen, die von einer geraden Linie abweichen. Hierbei kann es sich beispielsweise um Löcher oder um Abrundungen an den Ecken des Metallmaterials handeln. Solche Konturen können erhalten werden, in dem das Metallmaterial unter Anwendung des Lasers in dem erfindungsgemäßen Verfahren durchschnitten wird. Auch ist es möglich, entsprechende Konturen in ein Metall-Keramik-Substrat unter Laserablation des Metallmaterials und des Keramikmaterials zu erzeugen.

Wenn im Rahmen der vorliegenden Erfindung das Metallmaterial des Metall-KeramikMaterials unter Anwendung des Lasers durchtrennt wird, weisen die Schneidflanken einen Winkel auf, der üblicherweise um vorzugsweise maximal 30 °, weiter bevorzugt maximal 25 °, von einem rechten Winkel, gebildet von einer Senkrechten auf die Metallschicht bzw. das Metall-Keramik-Substrat, abweicht. Daraus ergibt sich ein Loch, das auf der Oberseite des Lasereintritts größer als auf der Unterseite ist.

Ein weiterer Vorteil der erfindungsgemäßen Durchtrennung des Metallmaterials und des Keramikmaterials eines Metall-Keramik-Substrats mit einem IR-Laser, insbesondere p-sec-IR-Laser, ist, dass an der Unterseite, d.h. der Laseraustrittseite, keine durch Schmelzphase gebildeten Grate entstehen, die in einem zusätzlichen Verfahrensschritt entfernt werden müssen.

Unter Berücksichtigung der oben beschriebenen Ausführungsformen ist es möglich, die Metallisierung und das Keramik-Substrat mit demselben Laser und unter denselben Prozessparametern zu bearbeiten. Hierdurch lässt sich kostengünstig eine Fertigung von Metall-Keramik-Substraten mit strukturierter Metallbeschichtung realisieren. Im Detail ist es möglich,
I) nur die obere Metallbeschichtung teilweise abzutragen oder bis zur Keramik zu durchtrennen und beispielsweise feine Strukturen in der Metallbeschichtung zu erzeugen, die mit einem Ätzvorgang nicht möglich sind;
II) die Metallbeschichtung und das Keramik-Substrat bis zur unteren Metallbeschichtung zu durchtrennen (damit kann die Grundlage für Durchkontaktierung geschaffen werden. Füllt man entsprechende Sacklöcher mit einem leitfähigen Material, ist eine Durchkontaktierung (Vias) hergestellt. Als Füllmaterial eignen sich beispielsweise metallische Pasten, metallische Formkörper, beispielsweise Zylinder, oder galvanisch erzeugte Materialien.);
III) Metallbeschichtung und Keramik-Substrat vollständig zu durchtrennen, um funktionale Ausnehmungen, z.B. zur Verschraubung, zu erzeugen.

Die erfindungsgemäßen Prozessparameter eignen sich dabei zur gleichzeitigen Laserablation von Metallisierung und Keramik-Substrat.

Das erfindungsgemäße Verfahren der Laserablation eines Metall-Keramik-Substrates kann in Gegenwart eines Prozessgases durchgeführt, wobei als Prozessgas beispielsweise Sauerstoff oder Druckluft verwendet werden kann. Wie bereits oben ausgeführt, ist die Verwendung eines Prozessgases nicht zwingend erforderlich, kann jedoch angeraten sein, um die Strahlquelle vor Verunreinigungen zu schützen. In diesem Fall würde sich die Verwendung von Druckluft als bevorzugte Alternative anbieten.

Da in dem erfindungsgemäßen Verfahren durch die Laserbearbeitung Stäube entstehen, ist es besonders bevorzugt, wenn die verwendete Vorrichtung eine Absaugvorrichtung aufweist, die Stäube absorbiert, welche durch die Laserbearbeitungen entstehen.

Die Absaugvorrichtung kann beispielsweise durch ein absaugendes Rohr oder einen absaugenden Kasten gebildet werden, der das projizierte Laserlicht umhüllt und dessen Unterkante einen Abstand zur Oberfläche des Metall-Keramik-Substrats von vorzugsweise 0,5 bis 10 cm, weiter bevorzugt von 0,75 bis 7,5 cm, noch weiter bevorzugt 1 bis 5 cm, aufweist.

Die Laserablation eines Metall-Keramik-Substrats im Rahmen der vorliegenden Erfindung kann beispielsweise durch Einwirken des Laserstrahls auf die Metallfläche des Metall-Keramik-Substrats erfolgen. Hierdurch wird die Bildung von Metallpartikeln, die sich auf den Oberflächen des Metall-Keramik-Substrats abscheiden, durch die Wahl der vorstehenden Verfahrensparameter reduziert.

Die Laserablation eines Metall-Keramik-Substrats im Rahmen der vorliegenden Erfindung kann beispielsweise auch durch Einwirken des Laserstrahls auf das Keramik-Substrat erfolgen. Diese Vorgehensweise ist bevorzugt, wenn mit der Laserablation eine Ausnehmung zum Befestigen des Metall-Keramik-Substrats erzeugt werden soll, da in diesem Fall das zur Befestigung verwendete Mittel (z.B. Schraube) hauptsächlich in Kontakt mit dem Metallmaterial steht und somit ein Abplatzen des Keramikmaterials durch Beanspruchung mit dem Befestigungsmittel verringert wird.

Weiterer Gegenstand der vorliegenden Erfindung ist ein Metall-Keramik-Substrat, welches nach dem oben beschriebenen Verfahren erhalten wird. Dieses Metall-Keramik-Substrat weist insbesondere eine bezogen auf die Metallschicht und Keramikschicht bündige Kante an einer durch Laserablation erzeugten Ausnehmung auf. Eine Ausnehmung kann hierbei auch eine Abschlusskante eines Metall-Keramik-Substrats sein.

Unter dem Begriff "einer bündigen Kante der Metallschicht und des Keramik-Substrats" wird im Rahmen der vorliegenden Erfindung verstanden, dass die Metallkante und die Kante des Keramik-Substrats einen parallel zur Kante verlaufenden maximalen Versatz von vorzugsweise maximal 20 µm, weiter bevorzugt maximal 15 µm, weiter bevorzugt maximal 10 µm, noch weiter bevorzugt maximal 5 µm, aufweisen.

Das erfindungsgemäße Metall-Keramik-Substrat kann eine durch die Behandlung mit dem IR-Laser erhaltene Kontur aufweisen, die von einer geraden Linie abweicht und die mittels Durchschneidens des Metall-Keramik-Substrats unter Verwendung eines Laserstrahls erzeugt wurde. Darüber hinaus ist es möglich, dass das erfindungsgemäße Metall-Keramik-Substrat Löcher und/oder Abrundungen an den Ecken aufweist, welche mittels des Durschneidens des Metall-Keramik-Substrats erzeugt wurden.

Die durch das IR-Laser-Verfahren mit einem p-sec-IR-Laser erhaltene Metall-Keramik-Substrat weist Schneidflanken mit einem Winkel auf, der um vorzugsweise maximal 30 °, weiter bevorzugt maximal 25 °, von einem rechten Winkel, gebildet von einer Senkrechten auf die Metallschicht bzw. das Metall-Keramik-Substrat, abweicht. Sollten durch das IR-Laser-Verfahren Löcher in das Metall-Keramik-Substrat eingebracht werden, so kann deren Größe auf den beiden Seiten des Keramiksubstrats unterschiedlich sein. Allerdings weist das Metall-Keramik-Substrat vorzugsweise an dem Loch und/oder Abrundung keinen Grat auf.

Durch das erfindungsgemäße IR-Laser-Verfahren sind Metall-Keramik-Substrate erhältlich, die eine Kodierung auf der Metallbeschichtung des Keramik-Substrats aufweisen. Diese Kodierung wird vorzugsweise durch ein Abtragen der Metallbeschichtung durch den IR-Laser bewirkt.

Mit dem erfindungsgemäßen Verfahren sind darüber hinaus Metall-Keramik-Substrate erhältlich, bei welchen die Metallisierung auf dem Keramiksubstrat mindestens eine Randabschwächung aufweist oder aber in welchen die Metallisierung mindestens eine Vertiefung zur Aufnahme von elektronischen Bauteilen, insbesondere Chips, aufweist, wobei die Vertiefung durch eine Laserbehandlung erzeugt wurde.

Das erfindungsgemäße Keramik-Metall-Substrat ist vorzugsweise ein DCB-Substrat (*direct copper bonded substrate*), ein AMB-Substrat (*acitve metal brazing substrate*) oder ein DAB-Substrat (*direct aluminum bonded substrate*). In einer weiteren Ausgestaltung der vorliegenden Erfindung kann es sich bei dem Keramik-Metall-Substrat um ein Keramik-Metall-Substrat gemäß der prioritätsälteren, nicht vorveröffentlichten Internationalen Patentanmeldung PCT/EP2016/082161 handeln.

Im Folgenden wird das im Rahmen der vorliegenden Erfindung vorzugsweise zu verwendende Keramik-Substrat näher beschrieben:

Das Keramiksubstrat enthält vorzugsweise wenigstens eine Verbindung, die aus der Gruppe ausgewählt ist, die aus Metalloxiden, Halbmetallnitriden und Metallnitriden besteht.

Dabei werden die Metalloxide und Metallnitride vorzugsweise aus der Gruppe ausgewählt, die aus Aluminiumoxid, Aluminiumnitrid und Siliziumnitrid besteht.

Die wenigstens eine Verbindung weist vorzugsweise Korngrößen im Bereich von 0,01 µm bis 100 µm auf.

Insbesondere handelt es sich bei der wenigstens einen Verbindung um Aluminiumoxid, wobei das Aluminiumoxid weiter bevorzugt Korngrößen im Bereich von 0,01 µm bis 25 µm aufweist.

Des Weiteren weist die wenigstens eine Verbindung vorzugsweise eine Anzahlverteilung der Korngrößen mit einem Medianwert d₅₀ und einem arithmetischen Mittelwert dₐᵣᵢₜₕ auf, wobei das Verhältnis von d₅₀ zu dₐᵣᵢₜₕ vorzugsweise im Bereich von 0,50 bis 1,50, bevorzugt im Bereich von 0,75 bis 1,10, noch bevorzugter im Bereich von 0,78 bis 1,05, besonders bevorzugt im Bereich von 0,80 bis 1,00, liegt.

Besonders bevorzugt ist die wenigstens eine Verbindung Aluminiumoxid und das Aluminiumoxid weist vorzugsweise eine Anzahlverteilung der Korngrößen mit einem Medianwert d₅₀ und einem arithmetischen Mittelwert dₐᵣᵢₜₕ auf, wobei das Verhältnis von d₅₀ zu dₐᵣᵢₜₕ vorzugsweise im Bereich von 0,75 bis 1,10, bevorzugter im Bereich von 0,78 bis 1,05, noch bevorzugter im Bereich von 0,80 bis 1,00 liegt.

Im Rahmen der vorliegenden Erfindung sind diese Werte nicht als strikte Unter- und Obergrenzen für die Korngrößenverteilung anzusehen, sondern können um +/- 10% variieren. In einer bevorzugten Ausführungsform handelt es sich jedoch um die Untergrenze, die nicht unterschritten wird, und Obergrenzen, die nicht überschritten wird.

Wie dem Fachmann grundsätzlich bekannt ist, kann die Bestimmung der Korngrößenverteilung unter Bezugnahme auf die Anzahl der Körner (d.h. Anzahlverteilung) oder alternativ auch unter Bezugnahme auf die Masse (d.h. Massenverteilung) oder das Volumen der Körner erfolgen. Im Rahmen der vorliegenden Erfindung wird die Verteilung der Korngrößen auf Basis der Körneranzahl bestimmt.

Wie allgemein bekannt ist, sind charakteristische Werte einer Korngrößenverteilung unter anderem deren d₅₀-Wert, d₅-Wert und d₉₅-Wert. Für den d₅₀-Wert, der häufig auch als Medianwert bezeichnet wird, gilt Folgendes: 50% der Körner weisen einen Durchmesser auf, der kleiner ist als der d₅₀-Wert.

Der arithmetische Mittelwert dₐᵣᵢₜₕ einer Korngrößenverteilung ergibt sich aus der Summe der Korngrößen der einzelnen Körner dividiert durch die Körneranzahl.

Die Symmetrie einer Korngrößenverteilung kann über das Verhältnis von Medianwert d₅₀ zu dem arithmetischen Mittelwert dₐᵣᵢₜₕ dieser Verteilung ausgedrückt werden (d.h. durch den Quotienten d₅₀/dₐᵣᵢₜₕ; auch als Symmetriewert einer Korngrößen-Anzahlverteilung bezeichnet). Je näher der Wert dieses Quotienten bei 1,0 liegt, desto symmetrischer ist die Korngrößenverteilung.

Geeignete Methoden, mit denen die Symmetrie der Korngrößenverteilung im Keramiksubstrat, insbesondere Aluminiumoxid, beispielsweise bereits bei der Herstellung des Ausgangssubstrats, eingestellt werden können, sind dem Fachmann bekannt. Beispielsweise kann die Symmetrie der Korngrößenverteilung durch Sinterdauer und Sintertemperatur bei der Herstellung des Ausgangssubstrats beeinflusst werden.

Die vorliegende Erfindung betrifft darüber hinaus die Verwendung eines Lasers mit den vorgenannten Merkmalen zur Ablation eines Metall-Keramik-Substrats

## Patentansprüche

1. Verfahren zur Ablation von einem Metall-Keramik-Substrat, **dadurch gekennzeichnet, dass** das Verfahren mit einem Laser durchgeführt wird, der unter Verfahrensbedingungen angewendet wird, welche die Bildung von festen Metallpartikeln auf dem Metall-Keramik-Substrat, die sich in der Umgebung der Ablationskante aus durch die Laserablation freigesetzten Metallpartikeln abscheiden können, im Wesentlichen vermeiden.

2. Verfahren nach Patentanspruch 1, **dadurch gekennzeichnet, dass** es sich bei dem Laser um einen p-sec-Laser handelt.

3. Verfahren nach Patentanspruch 1 oder 2, **dadurch gekennzeichnet, dass** die Bearbeitungsgeschwindigkeit des Lasers mindestens 0,50 m/sec beträgt.

4. Verfahren nach einem der Patentansprüche 1 bis 3, **dadurch gekennzeichnet, dass** die Bearbeitungsgeschwindigkeit des Lasers höchstens 10,00 m/sec beträgt.

5. Verfahren nach einem der Patentansprüche 2 bis 4, **dadurch gekennzeichnet, dass** der p-sec-Laser eine Pulsdauer von 0,10 bis 100,00 ps aufweist.

6. Verfahren nach einem der Patentansprüche 2 bis 5, **dadurch gekennzeichnet, dass** der p-sec-Laser eine Pulsenergie von 10,00 bis 500,00 µJ aufweist.

7. Verfahren nach einem der Patentansprüche 2 bis 6, **dadurch gekennzeichnet, dass** der p-sec-Laser eine Leistung von 20,00 bis 400,00 W aufweist.

8. Verfahren nach einem der Patentansprüche 2 bis 7, **dadurch gekennzeichnet, dass** der p-sec-Laser ein IR-P-sec-Laser ist.

9. Verfahren nach einem der Patentansprüche 1 bis 8, **dadurch gekennzeichnet, dass** es sich bei dem Metall um eine Kupferschicht oder Kupferfolie handelt, die auf einem Keramiksubstrat aufgebracht ist.

10. Verfahren nach einem der Patentansprüche 1 bis 9, **dadurch gekennzeichnet, dass** es sich bei dem Metall-Keramik-Substrat um ein DCB-Substrat handelt.

11. Metall-Keramik-Substrat, umfassend ein Keramiksubstrat und auf mindestens einer Seite des Keramiksubstrats eine Metallisierung, **dadurch gekennzeichnet, dass** das Keramiksubstrat und die Metallisierung eine Ausnehmung aufweisen, wobei die Ausnehmung eine mit der Metallisierung bündige Kante des Keramik-Substrats aufweist.

12. Metall-Keramik-Substrat nach Patentanspruch 11, **dadurch gekennzeichnet, dass** die Ausnehmung durch Laserablation erzeugt wird.

13. Metall-Keramik-Substrat gemäß Patentanspruch 11 oder 12, **dadurch gekennzeichnet, dass** das Metall-Keramik-Substrat ein DCB-Substrat ist.

14. Keramik-Metall-Substrat, erhältlich nach einem Verfahren gemäß einem der Patentansprüche 1 bis 10.

15. Verwendung eines Lasers mit den Merkmalen gemäß einem der Patentansprüche 2 bis 8 zur Ablation eines Metall-Keramik-Substrats.
